# EUROPÄISCHE PATENTANMELDUNG

(11) **EP 1 502 694 A2**
(43) Veröffentlichungstag der Anmeldung: **02.02.2005**
(21) Anmeldenummer: 04017190.2
(22) Anmeldetag: 21.07.2004
(51) Int. Cl.: B23K 9/32, B23K 10/00, B23K 10/02, B23K 26/20, B23K 26/38, B23K 37/00, B23K 35/02, F23D 14/54

(54) **Düse zum Schneiden oder Schweissen**

(71) Anmelder: Jürgen Bach Immobilien und Maschinen KG, 90425 Nürnberg (DE); Hollberg, Manfred, 9400 Rorschach (CH)
(72) Erfinder: Hollberg, Manfred, 9400 Rorschach (CH)
(74) Vertreter: Schneck, Herbert, Dipl.-Phys., Dr.

(57) **Zusammenfassung**

Die Düse (1) dient zum Schneiden oder Schweißen, insbesondere zum Laserschneiden oder -schweißen oder zum Plasmaschneiden oder -schweißen oder zum MIG/MAG-Schutzgasschweißen. Sie enthält einen Grundkörper (7) und eine auf dem Grundkörper (7) angeordnete Verschleißschutzschicht (2) aus einem Schutzschicht-Material, das einen Metall-Materialanteil und einen Nichtmetall-Materialanteil umfasst. Der Metall-Materialanteil enthält mindestens eines der Metalle Aluminium, Chrom und Titan. Der Nichtmetall-Materialanteil enthält mindestens eines der Elemente Stickstoff, Sauerstoff, Kohlenstoff und Bor, insbesondere in Form eines Nitrids, Oxynitrids, Carbonitrids oder Borids.

## Beschreibung

Die Erfindung betrifft eine Düse zum Schneiden oder Schweißen, insbesondere zum Laserschneiden oder -schweißen oder zum Plasmaschneiden oder -schweißen oder zum MIG/MAG-Schutzgasschweißen.

Düsen für die Schnitt- und Schweißbearbeitung unterliegen hoher Verschleißbeanspruchung. Eine solche Düse hat einen Grundkörper aus einer relativ weichen Kupfer- oder Messinglegierung, der deshalb nur einen geringen Widerstand gegenüber Oberflächenverschleiß aufweist. Durch auftretende Schmelzspritzer kann die Düse thermisch und mechanisch derart geschädigt werden, dass Zerstörungen am zu bearbeitenden Werkstück und auch an der Bearbeitungseinrichtung auftreten können.

Um eine derartige Beschädigung zu vermeiden, ist es bekannt, den Grundkörper der Düse mit einer Verschleißschutzschicht aus galvanisch aufgebrachtem Chrom zu versehen. Allerdings neigt eine derartige galvanische Chrom-Verschleißschutzschicht zu Schichtaufwerfungen im Bereich von Ecken und Kanten. Bei der Düse tritt dies vor allem im Bereich einer Austrittsöffnung eines Düsenkanals auf. Außerdem ist eine galvanische Innenbeschichtung des Düsenkanals auf Grund des erhöhten Schichtwachstums an der Austrittsöffnung und der damit verbundenen Verjüngung technisch nur sehr schwer zu beherrschen. Deswegen sind der Düsenkanal und insbesondere seine Austrittsöffnung nicht galvanisch mit Chrom beschichtet. Auftreffende Materialspritzer vom bearbeiteten Werkstück können die Düse dann gerade in diesen unbeschichteten Bereichen verkleben und verstopfen. Dies kann zu einer reduzierten Lebensdauer der Düse führen.

Die Aufgabe der Erfindung besteht nun darin, eine Düse der eingangs bezeichneten Art anzugeben, die eine hohe Lebensdauer aufweist.

Zur Lösung dieser Aufgabe wird eine Düse entsprechend den Merkmalen des Patentanspruchs 1 angegeben. Die erfindungsgemäß vorgesehene Verschleißschutzschicht zeichnet sich vor allem durch eine hohe thermische Beständigkeit, eine hohe Oxidationsbeständigkeit, einen hohen Schutz gegen Materialspritzer vom bearbeiteten Werkstück sowie eine hohe Haftfestigkeit auf der Kupfer- oder Messinglegierung des Grundkörpers aus. Das insbesondere keramische Schutzschicht-Material lässt sich vorzugsweise mittels einer Abscheidung aus einer Gasphase aufbringen. Dadurch können insbesondere auch das Innere und die Austrittsöffnung des Düsenkanals mit einer Verschleißschutzschicht versehen werden. Insgesamt resultiert gegenüber der bekannten Düse mit galvanischer Chrom-Verschleißschutzschicht eine deutliche Verbesserung hinsichtlich des mit der erfindungsgemäßen Düse erzielbaren Verschleißschutzes. Die erfindungsgemäße Düse kann damit auch deutlich länger eingesetzt werden.

Vorteilhafte Ausgestaltungen der erfindungsgemäßen Düse ergeben sich aus den von Anspruch 1 abhängigen Ansprüchen.

Die Variante nach Anspruch 2 führt zu einer Strukturverbesserung, insbesondere zu einer Kornverfeinerung, und damit zu einer sehr vorteilhaften Verschleißbeständigkeit. Verbessert wird auch die thermische Beständigkeit und die erzielbare Härte. Vorzugsweise liegt der kornverfeinernde Materialanteil bei etwa 0,5 bis 4 % bezogen auf die Summe der Atomprozente des Metall-Materialanteils und des kornverfeinernde Materialanteils im Schutzschicht-Material.

Weitere Merkmale, Vorteile und Einzelheiten der Erfindung ergeben sich aus der nachfolgenden Beschreibung von Ausführungsbeispielen anhand der Zeichnung. Es zeigt:
- Fig. 1: eine Düse mit einer Verschleißschutzschicht,
- Fig. 2: eine Anlage zur Erzeugung einer Verschleißschutzschicht und
- Fig. 3: einen Standzeit-Vergleich einer unbeschichteten Düse mit einer erfindungsgemäßen Düse.

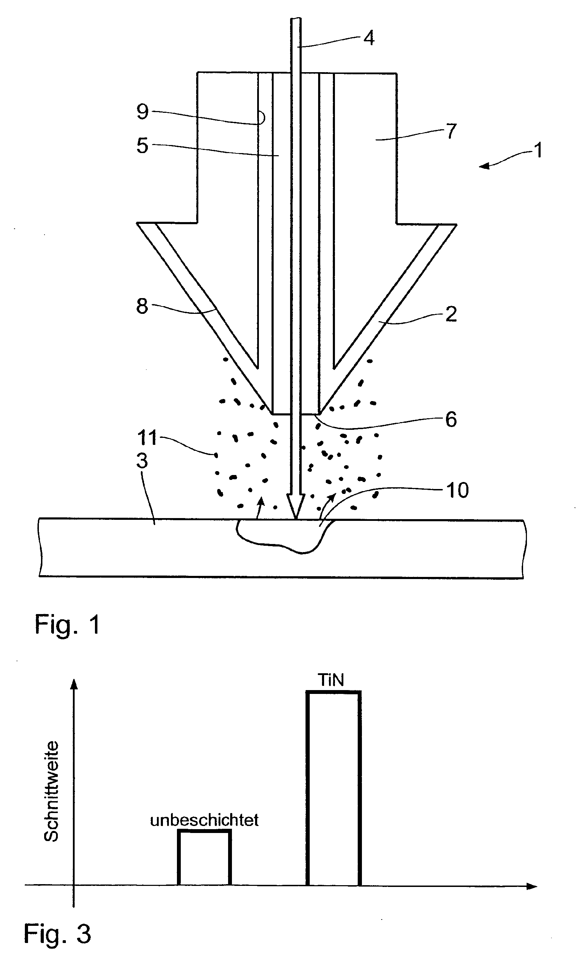

In Fig. 1 ist ein Ausführungsbeispiel einer Düse 1 mit einer Verschleißschutzschicht 2 in einer Querschnittsdarstellung gezeigt. Die Düse 1 ist Bestandteil einer nicht näher dargestellten Einrichtung zur Bearbeitung eines Werkstücks 3 mittels eines Laserstrahls 4. Die Düse 1 hat einen Düsenkanal 5 mit einer dem Werkstück 3 zugewandten Austrittsöffnung 6. Die Verschleißschutzschicht 2 ist auf einen Grundkörper 7 der Düse 1 aufgebracht, wobei die Verschleißschutzschicht 2 insbesondere an einer dem Werkstück 3 zugewandten Seite 8 des Grundkörpers 7 und vor allem auch an einer Innenwand 9 des Düsenkanals 5 sowie an der Austrittsöffnung 6 vorgesehen ist.

Grundsätzlich kann die Düse 1 bei verschiedenen Schneid- und SchweißTechniken, wie beispielsweise Laserschneiden oder -schweißen, Plasmaschneiden oder -schweißen oder MIG/MAG-Schutzgasschweißen, zum Einsatz kommen. Beim MIG/MAG-Schutzgasschweißen kann die Düse 1 für die Stromdüse und auch für die Gasdüse verwendet werden.

Der Laserstrahl 4 verläuft durch den Düsenkanal 5 und trifft nach Passieren der Austrittsöffnung 6 auf das Werkstück 3. Dort bewirkt er ein Aufschmelzen und letztendlich das beabsichtigte Zerschneiden des Werkstücks 3. Von einer durch den Laserstrahl 4 im Werkstück 3 erzeugten Schmelze 10 können sehr heiße und auch chemisch aggressive Materialspritzer 11 bis zur Düse 2 gelangen. Diese Materialspritzer 11 können sowohl beim im Beispiel gezeigten Schneiden als auch beim Schweißen auftreten. Dadurch kann die Düse 1 beschädigt werden. Deshalb ist sie zumindest an der Seite 8, im Düsenkanal 9 und an der Austrittsöffnung 6 mit der Verschleißschutzschicht 2 versehen.

Der Grundkörper 7 besteht aus einer relativ weichen und empfindlichen Kupfer- oder Messinglegierung, wohingegen für die Verschleißschutzschicht 2 ein sehr beständiges keramisches Schutzschicht-Material mit hoher Schutzwirkung vorgesehen ist. Das Schutzschicht-Material wird mittels eines physikalischen und/oder chemischen Gasphasen-Abscheideverfahrens auf den Grundkörper 7 aufgebracht.

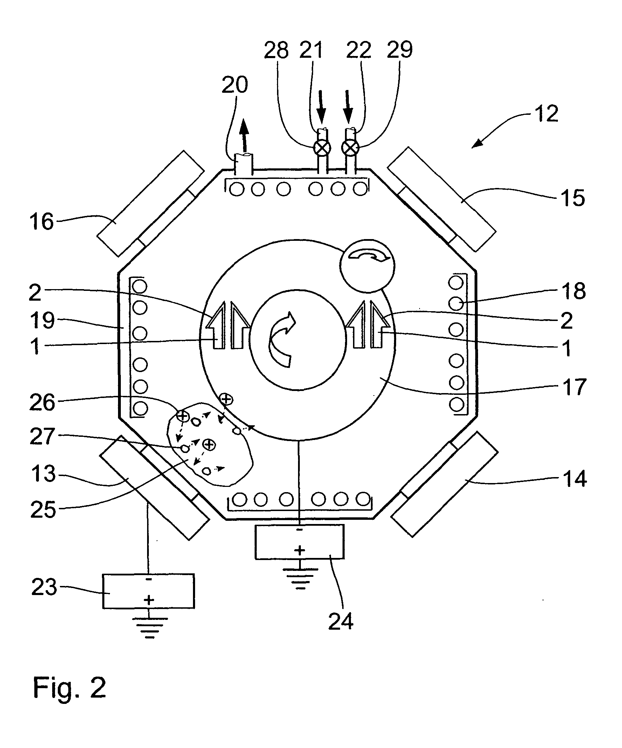

In Fig. 2 ist eine Anlage 12 dargestellt, mittels der ein solches Gasphasen-Abscheideverfahren durchgeführt werden kann. Die Anlage 12 arbeitet nach dem Sputter-Verfahren. Alternativ könnte jedoch ebenso ein anderes geeignetes Gasphasen-Abscheideverfahren, zum Beispiel ein PVD (Physical Vapour Deposition)-Arc-Verfahren oder ein Niedertemperatur-PACVD (Plasma Assisted Chemical Vapour Deposition)-Verfahren eingesetzt werden. Die so hergestellte Verschleißschutzschicht 2 hat vorzugsweise keramischen Charakter. Sie kann aber auch metallischen Charakter haben.

Die Anlage 12 hat ein Mehrkathodensystem mit im Beispiel von Fig. 2 gezeigten vier Kathoden 13, 14, 15 und 16, die auch als Target bezeichnet werden. Außerdem ermöglicht ein drehbarer Substrattisch 17, auf dem die zu beschichtende Düse 1, insbesondere um mindestens eine weitere Drehachse drehbar platziert ist, während des Beschichtungs-Vorgangs eine Rotation. Die mögliche Drehbewegung des Substrattisches 17 ist in Fig. 2 durch den Pfeil angedeutet.

Der Substrattisch 17 befindet sich in einem mittels Heizelementen 18 heizbaren und als Vakuumkammer ausgebildeten Rezipienten 19, an dem mehrere Anschlüsse 20, 21 und 22 vorgesehen sind. Der Anschluss 20 führt zu einer in Fig. 2 nicht gezeigten Vakuumpumpe. Die beiden Anschlüsse 21 und 22 dienen der Zuführung von Prozessgasen, beispielsweise eines Inertgases wie Argon (Ar) und von Reaktivgasen wie Stickstoff (N₂) oder Sauerstoff (O₂).

Mittels Spannungsquellen 23 und 24 können an die Kathoden 13, 14, 15 und 16 ebenso wie an den Substrattisch 17 vorgebbare Potentialwerte angelegt werden. Beispielhaft ist in Fig. 2 nur für die Kathode 13 ein solcher Anschluss an die Spannungsquelle 14 gezeigt. Der Substrattisch 17 und auch die Kathode 13 sind negativ vorgespannt, wobei die Vorspannung an der Kathode 13 beispielsweise 200 bis 400 V und die am Substrattisch 17 beispielsweise einige 10 bis 200 V beträgt.

Die Beschichtung erfolgt, indem zunächst beispielsweise mittels Zündung ein Plasma 25 mit positiven Inertgas-Ionen 26 gebildet wird. Auf Grund der hohen negativen Vorspannung der Kathode 13 werden die Inertgas-Ionen 26 in Richtung Kathode 13 beschleunigt. Beim Aufprall werden Sekundäratome 27 aus der Kathode 13 herausgeschlagen. Die Sekundäratome 27 bewegen sich als zerstäubte Target-Teilchen regellos und scheiden sich auf gegenüberliegenden Flächen, insbesondere auf dem Werkstück 3 ab.

Die negative Vorspannung des Substrattischs 17 und damit auch der darauf platzierten zu beschichtenden Werkstücke 3 dient zur Vermeidung von Verunreinigung. Die Verschleißschutzschicht 2 wird dann während des Wachstums ständig mit Inertgas-Ionen 26 bombardiert und damit von unerwünschten Adsorbaten gereinigt.

Die Kathoden 13, 14, 15 und 16 können unterschiedliche Material-Zusammensetzungen aufweisen. Sie können beispielsweise aus Metallverbindungen (AlₓTi_{y}, AlₓCr_{y}, AlₓTi_{y}Cr_{z}Yₙ, TiB₂) oder auch aus den Basismetallen (Al, Ti, Cr, Y) bestehen. Durch Veränderung der Material-Zusammensetzungen der Kathoden 13, 14, 15 und 16 lässt sich vor allem der Metall-Materialanteil der aufwachsenden Verschleißschutzschicht 2 in weiten Grenzen variieren.

Nichtmetallische Materialanteile der Verschleißschutzschicht 2 werden je nach gewünschter Material-Zusammensetzung insbesondere auch in Gasform zugeführt. Mit einer Variation der Reaktivgasanteile lässt sich der strukturelle Charakter hinsichtlich der Anteile von Nitriden, Oxiden, Carbonitriden oder deren Mischphasen beeinflussen. Eine solche Variation der Reaktivgasanteile ist sehr leicht über eine Kontrolle der zugeführten Gasmenge und -art möglich. Die Steuerung des Gaszuflusses erfolgt mittels in den Anschlüssen 21 und 22 vorgesehener Ventile 28 bzw. 29.

Mittels der Anlage 12 kann auch der strukturelle Aufbau der aufwachsenden Verschleißschutzschicht 2 beeinflusst und eingestellt werden. Insbesondere lässt sich eine monolagige, eine multilagige und eine nanokristalline Struktur erzeugen. Als Maßnahmen hierzu stehen beispielsweise eine Variation der effektiven Beschichtungszeit, eine Variation der Kathodenleistung, also der Verdampfungs- oder der Sputterrate, oder eine Variation der Drehgeschwindigkeit des Substrattischs 17 zur Verfügung. Die Beschichtungszeit bezüglich einer oder mehrerer der Kathoden 13, 14, 15 und 16 lässt sich zum Beispiel durch den Einsatz von in Fig. 2 nicht explizit gezeigten Shuttern steuern. Auch andere Prozesskenngrößen, wie die Temperaturführung, lassen sich mit der Anlage 12 variieren. Außerdem kann auch ein Plasmaätzen vorgesehen sein.

Die Anlage 12 eignet sich also zur Herstellung verschiedener Verschleißschutzschichten 2, die sich sowohl in der Material-Zusammensetzung als auch im strukturellen Aufbau unterscheiden können. Insbesondere ist ein ein- oder ein mehrlagiger Schichtaufbau möglich. Die bevorzugte Gesamtdicke der Verschleißschutzschichten 2 bewegt sich in einem Bereich zwischen 0,5 und 12 µm.

Herstellen lassen sich insbesondere Verschleißschutzschichten 2 mit Aluminium (Al), Titan (Ti) und/oder Chrom (Cr) als Metallkomponenten, mit Sauerstoff (O), Stickstoff (N), Kohlenstoff (C) und/oder Bor (B) als Nichtmetallkomponenten sowie mit Yttrium (Y), Niob (Nb), Zirkon (Zr) und/oder Wolfram (W) als kornverfeinernden Komponenten in weitgehend beliebiger Material-Zusammensetzung. Ein Beispiel ist eine Verschleißschutzschicht 2 aus AlTiCrY(O,N), bei der die Metalle Aluminium, Titan und Chrom sowie das zur Kornverfeinerung vorgesehene Metall Yttrium insbesondere in chemischer Bindung als Oxynitride vorliegen. Verschleißschutzschichten 2, bei denen diese Metalle andere chemischen Bindungen, beispielsweise in Form von Nitriden, Carbonitriden, Bornitriden oder Boriden, aufweisen, sind ebenfalls möglich.

Eine Untersuchung der verschiedenen Verschleißschutzschichten 2 liefert ihre jeweiligen Eigenschaften, insbesondere die Material-Zusammensetzung, den strukturellen Aufbau, die Härte, die Standzeit, die Haftfestigkeit, die Kratzfestigkeit, das Einsatzverhalten und die Schichtanbindung an den Grundkörper 7. Weiterhin können die Düsen 1 auch hinsichtlich der Haftwirkung der Materialspritzer 11 des zu schneidenden Werkstücks 3 sowie hinsichtlich des Verschleißfortschritts und des Verschleißerscheinungsbilds charakterisiert werden.

Zur chemischen Bestimmung der Material-Zusammensetzung kann ein EDX (Energy Dispersive X-ray)-, GDOS (Glow Discharge Optical Spectroscopy)- oder ein SIMS (Secondary Ion Mass Spectrometry)-Verfahren eingesetzt werden. Die Charakterisierung des strukturellen Aufbaus kann mittels einer metallografischen Untersuchung oder einer Raster-Elektronenmikroskopie (REM) erfolgen. Zur Bestimmung der Härte und auch der Elastizität eignet sich beispielsweise eine Kleinstlast-Universalhärteprüfung. Die Standzeit lässt sich anhand eines Praxistests der beschichteten Düsen 1 in einem Schneidautomaten untersuchen.

Diese Untersuchungen ergeben, dass die Düse 1 mit der Verschleißschutzschicht 2, die mittels des im Zusammenhang mit Fig. 2 beschriebenen Gasphasen-Abscheideverfahrens hergestellt wird, deutlich bessere Eigenschaften aufweist, als eine konventionelle Düse mit einer galvanisch aufgebrachten Chrom-Schutzbeschichtung. Vor allem kann die Verschleißschutzschicht 2 anders als eine galvanische Chrom-Schicht auch an der Innenwand 9 des Düsenkanals 5 und im Bereich der Austrittsöffnung 6 mit gutem Haftvermögen auf dem Grundkörper 7 aufgebracht werden. Außerdem kommt es im Bereich der Austrittsöffnung 6 zu keinen unerwünschten Schicht-Verdickungen, die dagegen bei einer galvanischen Chrom-Schicht vorhanden sein können. Weiterhin bietet die mittels des Gasphasen-Abscheideverfahrens hergestellte Verschleißschutzschicht 2 einen Schutz der Oberfläche der Düse 1, der gegenüber herkömmlichen galvanisch beschichteten Düsen zu einer wesentlichen Verschleißreduzierung führt.

Die vorstehenden Angaben gelten sowohl für Verschleißschutzschichten 2 mit einem monolagigen Aufbau, also mit einer im Wesentlichen homogenen Mischphase, als auch für solche mit einem mehrlagigen Aufbau aus mehreren Einzellagen. Die Einzellagen können sich in ihrer jeweiligen Material-Zusammensetzung gleichen oder auch voneinander unterscheiden. Eine besonders harte und zähe Verschleißschutzschicht 2 erhält man mittels einer so genannten nanostrukturierten Multilagenbeschichtung, bei der sehr feine Einzellagen mit Lagendicken zwischen 3 und 50 nm, vorzugsweise zwischen 3 und 20 nm vorgesehen sind. Auf Grund der geringen Lagendicke stellen sich vorteilhafte mechanische Spannungen zwischen den Einzellagen, die auch als Nanolagen bezeichnet werden, ein. Selbst bei auf Grund der Material-Zusammensetzung eigentlich nur zähen Einzellagen ergibt sich dank dieser mechanischen Spannungen für die Verschleißschutzschicht 2 insgesamt eine sehr hohe Härte. Weiterhin können in den Einzellagen wechselnde Anteile von Metall-Komponenten, vorzugsweise von Titan und Chrom vorgesehen sein. Ebenso möglich ist ein von Einzellage zu Einzellage variierender Sauerstoffgehalt. Die Material-Zusammensetzung der Einzellagen kann sich periodisch wiederholen. Sehr beständig wird die Verschleißschutzschicht 2 bei einem Multilagen-Aufbau, wenn die Gesamt-Schichtdicke mindestens 3 µm beträgt.

Im Folgenden werden Ausführungsbeispiele für Düsen 1 mit besonders günstigen mittels des Gasphasen-Abscheideverfahrens hergestellten Verschleißschutzschichten 2 beschrieben.

Ist die Düse 1 mit einer Verschleißschutzschicht 2 aus Chromnitrid (CrN) versehen, eignet sie sich für einen gemischten Einsatz, d. h. zum Schneiden von verschiedenen Werkstoffen wie Stahl, Edelstahl und beschichteten Blechen. Die höhere Härte und Temperaturbeständigkeit sowie der keramische Charakter der Verschleißschutzschicht 2 führen verglichen mit einer galvanischen Chrom-Beschichtung zu einem wesentlich geringeren Verschleiß der Düse 1.

Ist die Düse 1 mit einer Verschleißschutzschicht 2 aus Titannitrid (TiN) versehen, hat sie ein hervorragendes Standzeitverhalten beim Schneiden von kunststoffbeschichteten Blechen. Die Materialspritzer 11 des freigesetzten Kunststoffs haften nicht an der Düsenoberfläche oder lassen sich leicht wieder entfernen. In Fig. 3 ist ein Standzeit-Vergleich dieser TiN-beschichteten Düse 1 mit einer unbeschichteten Düse gezeigt. Mit der TiN-beschichteten Düse 1 kann eine deutlich größere Gesamt-Schnittweite erreicht werden.

Ist die Düse 1 mit einer Verschleißschutzschicht 2 aus Titanborid (TiB₂) versehen, hat sie ein hervorragendes Standzeitverhalten beim Schneiden von Aluminiumblechen. Die Materialspritzer 11 des freigesetzten Aluminium haften nicht an der Düsenoberfläche oder lassen sich leicht wieder entfernen.

Ist die Düse 1 mit einer Verschleißschutzschicht 2 aus einer TiAlCrY(O,N)-Multilagenbeschichtung versehen, hat sie sehr gute Standzeiteigenschaften, eine hohe Temperaturbeständigkeit von bis zu 1100°C, eine hohe Oxidationsbeständigkeit und eine hohe Härte von bis 3200 HV. Außerdem zeigt sie eine sehr gute Antihaftneigung und einen sehr guten Verschleißschutz. Sie ist daher besonders gut zum Hochleistungsschneiden von Stahlblechen geeignet.

Bei dem zuletzt genannten Ausführungsbeispiel hat die Verschleißschutzschicht 2 eine durchschnittliche Material-Zusammensetzung von:

| Metallanteil (Σ 100 %) | | | | Nichtmetallanteil (Σ 100 %) | |
|---|---|---|---|---|---|
| Al | Cr | Ti | Y | O | N |
| 72 % | 12 % | 15 % | 1 % | 5 % | 95 % |

Diese Verschleißschutzschicht 2 besteht aus einem Multilagen-Aufbau, deren Einzellagen sukzessive in der Anlage 12 mittels des Sputter-Verfahrens abgeschieden worden sind. Die Einzellagen haben eine Lagendicke von etwa 4 bis 6 nm, wobei sich die Einzellagen in ihrer jeweiligen Material-Zusammensetzung voneinander unterscheiden. Die Material-Zusammensetzung der Einzellagen wiederholt sich periodisch mit einem Periodenabstand von zwei Einzellagen. So variiert im Metallanteil der Chrom-Anteil zwischen 6 und 21 % und der Titan-Anteil zwischen 10 und 25 % sowie im Nichtmetallanteil der Sauerstoff-Anteil zwischen 1 und 8 %. Der Aluminium- und der Yttrium-Anteil bleiben dagegen im Wesentlichen konstant. Insofern sind die in der vorstehenden tabellarischen Zusammenstellung angegebenen Werte nur als über die gesamte Dicke aller Einzellagen gemittelte Durchschnittsangaben zu verstehen.

## Patentansprüche

1. Düse zum Schneiden oder Schweißen, insbesondere zum Laserschneiden oder -schweißen oder zum Plasmaschneiden oder -schweißen oder zum MIG/MAG-Schutzgasschweißen, mit einem Grundkörper (7) und einer auf dem Grundkörper (7) angeordneten Verschleißschutzschicht (2) aus einem Schutzschicht-Material, das einen Metall-Materialanteil und einen Nichtmetall-Materialanteil umfasst, wobei
a) der Metall-Materialanteil mindestens eines der Metalle Aluminium, Chrom und Titan
und
b) der Nichtmetall-Materialanteil mindestens eines der Elemente Stickstoff, Sauerstoff, Kohlenstoff und Bor, insbesondere in Form eines Nitrids, Oxynitrids, Carbonitrids, Bomitrids oder Borids, enthält.

2. Düse nach Anspruch 1, **dadurch gekennzeichnet, dass** das Schutzschicht-Material einen kornverfeinernden Materialanteil mit mindestens einem der Elemente Yttrium, Niob, Zirkon und Wolfram umfasst.

3. Düse nach Anspruch 1, **dadurch gekennzeichnet, dass** das Schutzschicht-Material in einer homogenen Mischphase vorliegt.

4. Düse nach Anspruch 1, **dadurch gekennzeichnet, dass** die Verschleißschutzschicht (2) als eine Multilagenbeschichtung mit Einzellagendicken zwischen 3 und 50 nm, vorzugsweise zwischen 3 und 20 nm, ausgebildet ist.

5. Düse nach Anspruch 4, **dadurch gekennzeichnet, dass** die Einzellagen der Multilagenbeschichtung zumindest teilweise eine voneinander verschiedene Materialzusammensetzung aufweisen.

6. Düse nach Anspruch 1, **dadurch gekennzeichnet, dass** die Verschleißschutzschicht (2) eine Gesamtdicke von etwa 0,5 bis 12 µm aufweist.

7. Düse nach Anspruch 1, **dadurch gekennzeichnet, dass** die Verschleißschutzschicht (2) keramisch ausgebildet ist.

8. Düse nach Anspruch 1, **dadurch gekennzeichnet, dass** die Verschleißschutzschicht (2) als eine aus einer Gasphase abgeschiedene Schicht ausgebildet ist.

9. Düse nach Anspruch 1, **dadurch gekennzeichnet, dass** der Grundkörper (7) einen Düsenkanal (5) mit einer einem zu bearbeitenden Werkstück (3) zugewandten Austrittsöffnung (6) aufweist und die Verschleißschutzschicht (2) auch an der Austrittsöffnung (6) angebracht ist.

10. Düse nach Anspruch 9, **dadurch gekennzeichnet, dass** der Grundkörper (7) einen Düsenkanal mit einer Innenwand (9) aufweist und die Verschleißschutzschicht (2) auch an der Innenwand (9) angebracht ist.
